# EUROPEAN PATENT SPECIFICATION

(11) **EP 0 358 407 B1**
(45) Date of publication and mention of the grant of the patent: **18.10.1995**
(21) Application number: 89308812.0
(22) Date of filing: 31.08.1989
(51) Int. Cl.: H01L 29/737, H01L 29/36, H01L 29/205

(54) **Bipolar hot electron transistor**
Bipolarer Heisselektronen-Transistor
Transistor bipolaire à électrons chauds

(30) Priority: 07.09.1988 US 241279
(43) Date of publication of application: 14.03.1990
(73) Proprietor: AT&T Corp., New York, NY 10013-2412 (US)
(72) Inventor: Levi, Anthony Frederic John, Summit New Jersey 07901 (US)
(74) Representative: Watts, Christopher Malcolm Kelway, Dr.

(56) References cited:
- EP-A- 0 306 258
- PATENT ABSTRACTS OF JAPAN vol. 11, no. 130 (E-502)(2577) 23 April 1987 ; & JP-A-61 276 261
- APPLIED PHYSICS LETTERS, vol. 49, no. 17, 27 October 1986, NEW YORK US, pp. 1112-1114; R.N. Nottenburg et al.: "High Gain InGaAs/InP Heterostructure Bipolar Transistors Grown By Gas Source Molecular Beam Epitaxy"
- IEEE ELECTRON DEVICE LETTERS, vol. 10, no. 6, June 1989, NEW YORK US, pp. 267-269; Y.-K. Chen et al.: "Subpicosecond InP/inGaAs Heterostructure Bipolar Transistors"
- INSTITUTE OF PHYSICS CONFERENCE SERIES, no. 79, Chapter 11 (Int. Symp. on GaAs and Related Compounds, September 1985), pp. 595-600 (Lievin et al.)
- IEEE ELECTRON DEVICE LETTERS, vol. EDL-8, no. 9, September 1987, pp. 383-385 (Wang et al.)
- JOURNAL OF APPLIED PHYSICS, vol. 62, no.9, November 1987, pp. 3976-3979 (Chen et al.)

## Description

### Field of the Invention

This application pertains to the field of active semiconductor devices. In particular, it pertains to bipolar transistors in which at least a substantial fraction of the current is carried by hot electrons.

### Background of the Invention

It has been known for some time that a hot electron transistor could potentially be operated at frequencies in excess of those achievable with conventional (diffusive) transistors. See, for instance, T. E. Bell, IEEE Spectrum, February 1986, pp. 36-38. Various types of hot electron transistors (HET) have been proposed. This application is concerned with one particular class of such transistors, namely, heterojunction bipolar HETs. For a brief review, see L. F. Eastman, ibid, pp. 42-45.

The flow of electrons from emitter to collector in a bipolar transistor is controlled by varying the emitter/base barrier potential by means of an applied voltage V_{eb}, and is also a function of an externally applied voltage V_{bc} between base and collector. Under normal operating conditions, V_{bc} reverse biases the base/collector junction. Electrons injected from the emitter into the base of a bipolar HET have energy substantially greater than the thermal energy of the ambient electrons in the base. The "hot" electrons ideally traverse the base without undergoing significant scattering. If the base/collector barrier is caused to be lower than the hot electron energy then some of the hot electrons can cross the barrier, be transmitted through the depletion region of the collector, and enter the sea of conduction electrons in the collector contact region.

As will be readily understood by those skilled in the art, various difficulties have to be overcome before a device of this type can function as a practical HET. Among these is the difficulty of achieving substantially complete hot electron transport through the base, and, desirably, also through the depletion region of the collector.

EP-A-0 299 686 discloses means for achieving improved HETs. However, in view of the general desirability of improved characteristics such as larger β and high cut-off frequency, means for achieving further improvements in HET characteristics would be of considerable significance. This application discloses HETs comprising such means.

EP-A- 0 306 258, which forms part of the state of the art by virtue of Article 54(3) EPC, discloses a heterojunction bipolar transistor in which the base comprises a submonolayer of Be atoms.

Lievin et al., Institute of Physics Conference Series, No. 79, chapter 11 (Int. Symp. on GaAs and Related Compounds, Sept. 1985), pp. 595-600 disclose a GaAlAs/GaAs heterojunction bipolar transistor with base doping level of 2×10²⁰Be/cm³.

Wang et al., *IEEE Electron Device Letters*, Vol. EDL-8 (9), pp. 383-385, disclose a heterojunction bipolar transistor with InGaAs p-type base doped 1×10²⁰ cm⁻³.

*Patent Abstracts of Japan*, Vol. 11 (130) (E-502) [2577], JP-A-61 276 261 discloses a bipolar transistor with δ-doped base and emitter.

Chen et al., *Journal of Applied Physics*, Vol. 62 (9), pp. 3976-3979, disclose a double-heterojunction bipolar transistor that comprises a 50 nm n-type spacer between the base and the N collector layer whereby the voltage spike at the base/collector interface is smoothed out.

### Definitions

A conduction electron herein is considered to be a "hot" electron in a given semiconductor region if its energy E is substantially greater than the ambient thermal energy k_{B}T. Typically, E ≧ 10k_{B}T, where k_{B} is the Boltzmann constant, and T is the absolute temperature of the lattice.

A "hot electron" transistor (HET) is a transistor whose operative characteristics are in substantial part determined by the transport of hot electrons through the transit region of the transistor, with minimal scattering of the hot electrons in the transit region.

The "transit region" of a HET herein is that portion of the HET through which substantial hot electron transport takes place, or is intended to take place. For instance, in a bipolar transistor, the transit region consists of the base and the collector depletion region. In order to have the possibility of significant hot electron transport in a HET, the width of the transit region has to be less than the mean-free path of the hot electrons in the material.

The "ambient" charge carriers are those charge carriers (electrons or holes) that are essentially in thermal equilibrium with the lattice. For instance, in n-p-n bipolar HETs the ambient charge carriers in the base are holes.

Electron scattering is herein considered to be "elastic" or "inelastic" if the associated change in energy of the electron is, respectively, less or greater than Δ = h/2πτₕₒₗₑₛ, wherein h is Planck's constant and τₕₒₗₑₛ = m*µ/e, where m* is the effective hole mass, µ is the hole mobility, and e is the electron charge. (See, for instance, N. D. Mermin, Physical Review B, Vol. 1, pp. 2362-2363, 1970.) Exemplarily, in GaAs with a p-type impurity concentration of 2x10²⁰cm⁻³, µ is about 50 cm²/V-sec, yielding Δ of about 46 meV.

### Brief Description of the Drawings

FIG. 1 schematically depicts a device according to the invention;
FIG. 2 shows schematically some features of the conduction band structure of a device according to the invention;
FIGS. 3 and 4 show exemplary curves, respectively, of the inelastic and elastic electron scattering rates in p-type GaAs as a function of dopant concentration.

### The Invention

In a broad sense, I am herein teaching design features that can be used to produce HETs having improved characteristics. For instance, the inventive features can result in compound semiconductor bipolar HETs that are capable of operation at frequencies higher than those attainable with prior art transistors. Such transistors can be used in a variety of applications, e.g., in repeaters in high bit-rate optical fiber transmission systems.

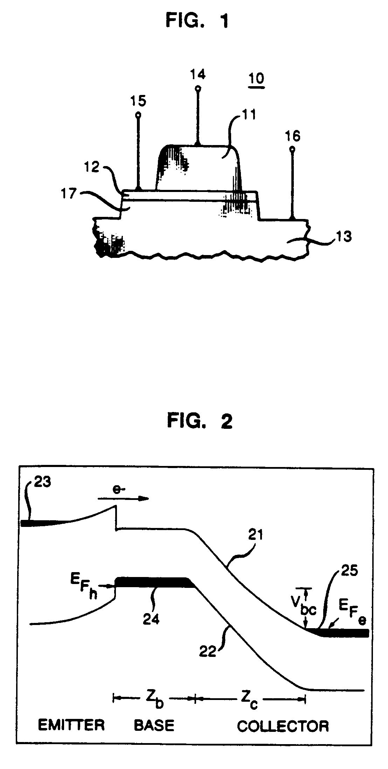

HETs of interest herein generally have geometries similar to those of prior art HETs, although typically critical dimensions such as Z_{b} and Z_{c} (see FIG. 2) are scaled down. As set out in claim 1, the HETs according to the present invention comprise an electron emission region ( the first region), an electron collection region (the third region), and a second region that is intermediate the first and third regions and forms interfaces therewith. The first region comprises an emitter layer, and the second region comprises a base layer, with, typically, the emitter layer contacting the base layer and forming the emitter/base interface therewith. The base layer is typically also in contact with third region material and forms the base/collector interface therewith. The first, second and third regions each generally consist of one or more layers of compound semiconductor material, with the composition of the base layer differing from that of the emitter layer. The second region material is the same as the third region material, with the second and third region materials containing different dopants and/or differing in dopant concentration. The third region comprises an undoped portion of thickness Z_{c} (≦100nm) in contact with the second region, and a relatively highly doped portion that is spaced apart from the second region.

HETs of interest herein also comprise means making electrical contact with the first, second and third regions, respectively, and means for injecting hot electrons from the first into the second region. At least a substantial fraction (advantageously > 90%) of the injected hot electrons transit the second region without substantial energy loss and cross the base/collector interface. The injected hot electrons have average energy Eᵢ.

Particular embodiments of the invention are disclosed in the dependent claims.

As will be readily appreciated by those skilled in the art, in a HET a substantial portion of the hot electrons that are injected into the second region must traverse the second region and the remainder of the transit region without becoming thermalized through inelastic scattering and, desirably, without undergoing appreciable elastic or inelastic scattering. This suggests as a desirable design goal transistors having relatively low dopant concentration in the transit region. On the other hand, a high cut-off frequency can only be achieved if the sheet resistance R_{b} associated with the application of a control signal to the second region is relatively low. Low R_{b} requires a high dopant concentration in the second region. Thus there exist conflicting requirements which have resulted in design compromises in the prior art and prevented desirable scaling down of device size.

FIG. 1 schematically depicts a HET 10 according to the invention, wherein numerals 11, 12, and 13 refer, respectively, to the first, second, and third regions of the transistor. In many cases these regions can be directly identified with emitter, base, and collector, respectively. Each of the regions may comprise more than one layer of semiconductor material. Portion 17 of the third region is a collector depletion region, and numerals 14, 15, and 16 refer to means making electrical contact to the first, second, and third regions, respectively. Transistors according to the invention may be discrete devices but are more likely part of an integrated circuit, as will be appreciated by those skilled in the art. Discrete transistors as well as the integrated circuits can be produced by known methods, typically including molecular beam epitaxy (MBE) and/or metal-organic chemical vapor deposition (MOCVD).

FIG. 2 schematically shows the energy diagram associated with an exemplary inventive HET under bias. Such diagrams are well understood by those skilled in the art. THe regions labeled "emitter", "base", and "collector" refer to the first, second, and third regions of the transistor, respectively, and numerals 21 and 22 refer to the lower conduction band edge and the upper valence band edge, respectively. The arrow indicates the direction of hot electron flow, with numeral 23 referring to the sea of conduction electrons in the emitter region, 24 to the holes in the valence band in the base region, and 25 to the sea of conduction electrons in the collector contact region. The base region is of thickness Z_{b}, and the collector depletion region of thickness Z_{c}. Z_{b} and Z_{c} together are the thickness of the transit region, which is advantageously kept to a minimum consistent with other design parameters such as R_{b}. E_{F,h} and E_{F,e} are, respectively, the Fermi energy of the holes in the base region and of the electrons in the collector region. V_{bc} is the potential difference, due to an externally applied voltage, between base and collector.

I have made a quite unexpected discovery which will permit the practitioner to design HETs capable of improved high frequency behavior. As a consequence of the newly discovered property, the above discussed conflicting requirements on the doping of the second region are at least far less severe than previously thought. In particular, I have discovered that the inelastic scattering rate 1/τᵢₙ associated with hot electrons of a given energy Eᵢ in many semiconductor materials of interest for HETs (e.g., GaAs, AlGaAs, In_{0.53}Ga_{0.47}As) goes through a maximum as a function of the average density of dopant atoms (n_{b}), and can be significantly lower than its value at n_{b,max} if n_{b} > n_{b,max}, where n_{b,max} is the density of dopant atoms at the maximum of 1/τᵢₙ. The inelastic scattering time is designated as τᵢₙ.

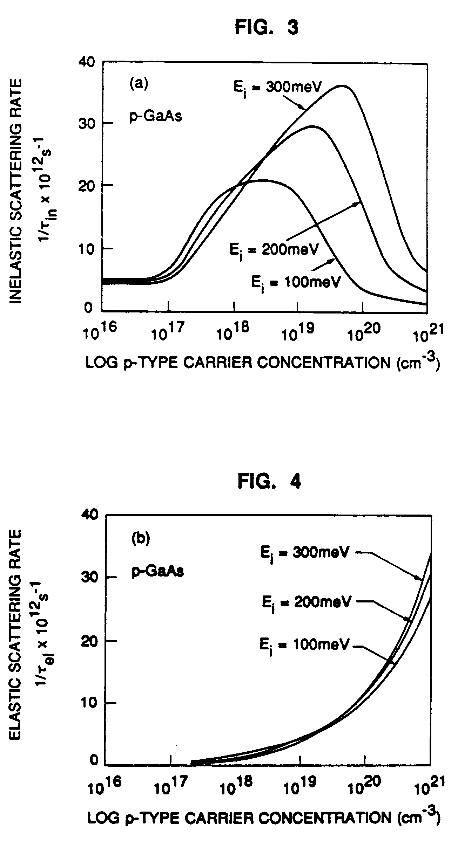

The inelastic scattering rate for hot electrons in p-doped GaAs is shown in FIG. 3 as a function of dopant level. As can be seen, the scattering rate is a function of Eᵢ for most dopant levels of interest and has a pronounced maximum. For high doping levels (e.g., n_{b} ≧ 10²⁰cm⁻³) the inelastic scattering rate can actually be less than for low doping levels (e.g., n_{b} ≦ 10¹⁷cm⁻³). Similar results apply to other compound semiconductor materials useful in the practice of the invention. Thus, in devices according to the invention the average dopant concentration in the base typically is at least 10²⁰cm⁻³, frequently 2x10²⁰cm⁻³ or greater.

As a consequence of the unexpected decrease of the inelastic scattering rate for high doping levels, it is possible to design HETs that have both relatively low R_{b} and low 1/τᵢₙ. This can be achieved by selecting the doping level in the second region such that n_{b} > n_{b,max}, for the given operative value of Eᵢ. The value of n_{b,max} for a given semiconductor material can be determined by a calculation of the type used to produce the results shown in FIG. 3, or it can be determined experimentally, by carrying out I/V measurements at low temperatures on a series of otherwise identical HETs that differ only with regard to n_{b}.

It is to be understood that the above remarks pertain to the inelastic scattering rate. The behavior of the elastic scattering rate in GaAs as a function of the level of randomly distributed p-type dopant is shown in FIG. 4. As can be seen from the figure, for dopant levels above about 5x10²⁰cm⁻³ elastic scattering from dopant ions is the dominant scattering mechanism for hot electrons in p-type GaAs, if the ions are randomly distributed. Similar results obtain for the other semiconductor materials referred to above.

In preferred embodiments of the invention the dopant atoms in the second region are not randomly distributed, as has been customary up to now, but are instead at least partially ordered, whereby the elastic scattering rate of the hot electrons can be significantly reduced. An exemplary technique for attaining such ordering in the direction parallel with the current flow is delta-doping (see, for instance, E. F. Schubert et al, Physical Review B, Vol. 36 (1987) pp. 1348-1351), whereby a spatially non-uniform distribution of dopant atoms is produced. Typically such a distribution comprises one or more thin "sheets" of highly doped material, the sheets being parallel to the emitter/base interface. Another exemplary technique for attaining ordering may comprise the formation of an ordered alloy (see A. Gomyo et al, Physical Review Letters, Vol. 60(25) (1988), pp. 2645-2648) in the second region. In this case the dopant atoms in the second region form part of the alloy's periodic lattice.

I have made a further discovery that can also contribute to improved characteristics of HETs. In such devices, it is typically required that the hot electrons that have transited the second region and have been transmitted through the second/third region interface also be able to travel through the remainder of the transit region (typically the collector depletion region) substantially without scattering.

In many prior art HETs a significant scattering mechanism in (100)-oriented III-V semiconductors is (intraband) intervalley scattering from the Γ to the X valley (those skilled in the art are familiar with this terminology). Electrons typically are injected into the Γ valley in the second region, and it is advantageous to keep the electrons in that valley throughout their traverse of the transit region. The likelihood of Γ→X intervalley scattering in the transit region can be significantly reduced if the average time the hot electrons spend in the part of the transit region in which Γ→X scattering is possible is less than the average scattering time for Γ to X scattering (designated τ_{Γ-X}) in the semiconductor material. The relevant part of the transit region in which Γ→X scattering is possible depends on V_{bc} and the thickness Z_{c}. With the base/collector reverse biased to V_{bc}=1 volt the portion of the third region in which Γ→X scattering can take place is about 0.79 Z_{c} for GaAs and about 0.33 Z_{c} for In_{.53}Ga_{.47}As. Since τ_{Γ-X} in many of the semiconductors of interest herein can be estimated to be of the order of about 50 fs, in most III-V semiconductors of interest herein Z_{c} desirably is less than about 100 nm, in order to insure at least a relatively low Γ→X scattering probability in the transit region. For instance, if Z_{c} ≦ 50 nm in GaAs then little Γ→X scattering takes place in the transit region for relevant values of Eᵢ and V_{bc}; for In_{.53}Ga_{.47}As the same is true is Z_{c} ≦ 70 nm. Thus, in some preferred devices according to the invention the third region comprises an undoped or relatively lightly doped portion of thickness Z_{c} in contact with the second region, and a relatively highly doped portion that is spaced apart from the second region, with Z_{c} being at most about 100 nm.

In preferred HETs according to the invention there are also limits on V_{bc} (see FIG. 2). To avoid interband scattering the electrons can be accelerated in the third region only to an energy less than E_{bw}, the energy width of the conduction band in the third region. This implies that eV_{bc,max} ≦ E_{bw} - E_{g} - E_{F,e} - E_{F,h}, where e is the electron charge, V_{bc,max} is the maximum allowed V_{bc}, E_{g} is the bandgap in the third region material, and E_{F,e} and E_{F,h} are, respectively, the Fermi energy of the electrons in the contact portion of the third region and of the holes in the second region. On the other hand, in order to achieve short transit times and thus, potentially, high cut-off frequencies, as well as high output impedance, it would be desirable to be able to use relatively large V_{bc}. In preferred devices according to the invention, the collector contact region is relatively heavily doped, exemplarily containing more than about 10¹⁹cm⁻³, preferably more than 5 x 10¹⁹cm⁻³, dopant atoms.

In particularly preferred HETs according to the invention the third region comprises a material which has relatively large E_{bw}-E_{g} (relative to GaAs, which has E_{bw} ∼ 2.0 eV and E_{g} ∼ 1.4 eV) since such devices can have a relatively large operating voltage range of V_{bc}. Exemplarily, In_{.53}Ga_{.47}As is such a material.

In an exemplary embodiment of the invention the emitter (11) is n-type InP (5x10¹⁷cm⁻³ dopant atoms, e.g., Si) and the base (12) and collector (13) are In_{.53}Ga_{.47}As. The thickness of the base layer (Z_{b}) is about 40 nm, and the thickness Z_{c} of the collector depletion region (17) is about 70 nm. The base consists, in sequence, of a 5 nm thick, essentially undoped, set-back layer, followed by 6 δ-doped sheets, with 6 nm spacing between sheets, followed by another 5 nm set-back layer. Each δ-doped sheet contains 1x10¹⁴cm⁻² p-type dopant atoms (e.g., Be), resulting in an average dopant concentration of 2x10²⁰cm⁻³ in the relevant portion of the base layer. As will be appreciated, a δ-doped layer is at most a few atomic layers thick. The thus produced spatially non-uniform distribution of dopant atoms is expected to result in reduced elastic scattering of the hot electrons, as opposed to prior art HETs with randomly distributed dopant atoms in the base region. The n⁺ collector contact region is about 300 nm thick, with a dopant density of 5x10¹⁹cm⁻³. The device is produced by known techniques, exemplarily including MBE, lithography and plasma etching. Electrical contacts (14, 15, 16) are made by a conventional technique.

In a further exemplary embodiment of the invention a HET is made substantially as described above, except that Al_{.35}Ga_{.65}As is used to form the emitter layer, and GaAs is used for base and collector, with Z_{c} being 50 nm. In other embodiments the base layer contains 2 δ-doped sheets of p-type dopant atoms (areal density 3x10¹⁴cm⁻²) instead of the previously described six. The sheets are 30 nm apart, resulting in an average dopant density of 2x10²⁰cm⁻³. This doping scheme is expected also to result in reduced elastic scattering.

The above referred to δ-doping produces a non-random distribution in the growth direction but normally would not result in ordering within the doped sheets. At least partial ordering within the doped sheets is expected to be obtainable by appropriate choice of deposition conditions. Such ordering is expected to result in further reduction of elastic scattering of the hot electrons, and therefore in improved device performance.

Deposition conditions that are expected to result in at least partial inplane ordering are a relatively low substrate temperature (typically less than about 500°C) together with an overpressure (or underpressure) of an appropriate element in the growth atmosphere. For instance, if Be is the dopant then overpressure (the partial pressure typically being at least 150% of the normal partial pressure) of As ensures that the Be atoms will preferentially be located on Ga sites. On the other hand, if the dopant is C then an underpressure (the partial pressure typically being at most 75% of the normal partial pressure) of As, combined with the deposition of a fraction of a monolayer (e.g., about 1/2 monolayer) of Ga, ensures preferential location of C on As sites. The low substrate temperature prevents substantial surface diffusion of the deposited atoms, the procedure thus resulting in partial ordering of the dopant atoms. Partial ordering is currently considered to result in substantial reduction in 1/τₑₗ if the Fourier transform of the distribution function for the dopant atoms has a value of at most 0.1 in the range 0 ≦ k ≦ kᵢ, where kᵢ is the average wave vector of the injected hot electrons. Ordering that meets the above requirement will be referred to as "substantial" ordering. The distribution function can, at least in principle, be determined by known techniques such as scanning tunneling microscopy or electron diffraction.

"Partial ordering" in many herein relevant situations exists if the probability of finding a dopant atom on one type of lattice site (e.g., the Ga site in GaAs) is substantially different from the probability of finding such an atom on the other type of lattice site (e.g., the As site in GaAs).

## Claims

1. A bipolar hot electron transistor (10) comprising
a) an electron emission region (11) hereinafter called "the first region", an electron collection region (13) hereinafter called "the third region", and a second region (12) intermediate the first and third regions, forming interfaces and being epitaxial therewith, the first, second, and third regions each consisting of semiconductor material, the composition of the second region material differing from that of the first region material at the first/second region interface and being the same as the composition of the third region material, at least a part of each of the first and third regions having n-type conductivity, and at least a part of the second region having p-type conductivity, associated with the second region being a thickness Z_{b}, a base resistance R_{b}, an average dopant density n_{b}, an inelastic scattering rate 1/τᵢₙ for the hot electrons, and an elastic scattering rate 1/τₑₗ for the hot electrons, the second region material being such that the inelastic scattering rate 1/τᵢₙ varies as a function of the average dopant density of the material and has a maximum for a given value of Eᵢ, with the average dopant density of the material at the maximum to be referred to as n_{b,max} and n_{b} being greater than n_{b,max};
b) means making electrical contact (14, 15, 16) with the first, second, and third regions, respectively; and
c) means adapted for causing injection of hot electrons of average energy Eᵢ from the first into the second region, at least a substantial portion of the injected hot electrons crossing the interface between the second and third region;
**CHARACTERIZED IN THAT**
d) the third region comprises an undoped or relatively lightly doped portion of thickness Z_{c} in contact with the second region, and a relatively highly doped portion that is spaced apart from the second region, with Z_{c} being at most 100 nm.

2. The transistor of claim 1, wherein nb is at least 10²⁰cm⁻³.

3. The transistor of claim 1, wherein the dopant atoms in the second region have a non-random distribution, whereby the elastic scattering rate (1/τₑₗ ) of the hot electrons is substantially lower than in an otherwise identical transistor in which the dopant atoms in the second region have a random distribution.

4. The transistor of claim 3, wherein the non-random distribution comprises a spatially non-uniform distribution comprising one or more layers of relatively highly doped material with, in the case of more than one highly doped layer, a layer of undoped or relatively lightly doped material between any two adjacent highly doped layers.

5. The transistor of claim 3, wherein the non-random distribution comprises substantial ordering of the dopant atoms in at least a part of the second region.

6. The transistor of claim 5, wherein said part of the second region is a layer of relatively highly doped material that is separated from a similar layer by a layer of undoped or relatively lightly doped material.

7. The transistor of claim 1, wherein the third region is made of a compound semiconductor material having a conduction band width E_{bw} and a bandgap width E_{g} such that E_{bw}-E_{g} is substantially larger than E_{bw}-E_{g} of GaAs.

8. The transistor of claim 1, wherein the first region comprises n-type InP.

9. The transistor of claim 1, wherein
i) n_{b} is at least 2 × 10²⁰cm⁻³;
ii) the dopant atoms in the second region have a spatially non-uniform distribution comprising at least two layers of relatively highly doped material with a layer of undoped or relatively lightly doped material therebetween.
iii) the dopant atoms in the at least two layers are substantially ordered;
iv) the second and third regions are made of a compound semiconductor material having a conduction band width E_{bw} and a bandgap width E_{g} such that E_{bw}-E_{g} is greater than about 0.6 eV; and
v) the relatively highly doped portion of the third region contains at least 10¹⁹ dopant atoms/cm³.

## Patentansprüche

1. Bipolarer Transistor (10) mit heißen Elektronen umfassend
a) einen Elektronenemissionsbereich (11), nachfolgend als "der erste Bereich" bezeichnet, ein Elektronensammelbereich (13) nachfolgend als "der dritte Bereich" und einen zweiten Bereich (12) zwischen dem ersten und dem dritten Bereich, der Grenzflächen ausbildet und zu diesen epitaxial ist, wobei der erste, zweite und dritte Bereich jeder aus Halbleitermaterial besteht, wobei die Zusammensetzung des Materials des zweiten Bereichs anders als diejenige des Materials des ersten Bereichs an der Grenzfläche des ersten/zweiten Bereichs ist und die gleiche ist wie die Zusammensetzung des Materials des dritten Bereichs, wobei wenigstens ein Teil des ersten und des dritten Bereichs n-Typ-Leitfähigkeit hat und wenigstens ein Teil des zweiten Bereichs p-Typ-Leitfähigkeit hat, wobei dem zweiten Bereich eine Dicke Z_{b}, ein Basiswiderstand R_{b} und eine mittlere Dotierstoffdichte n_{b} und eine inelastische Streurate 1/τᵢₙ für die heißen Elektronen, und eine elastische Streurate 1/τₑₗ für die heißen Elektronen zugeordnet ist, wobei das Material des zweiten Bereichsn so ist, daß die inelastische Streurate 1/τᵢₙ sich als Funktion der mittleren Dotierstoffdichte des Materials ändert und ein Maximum für einen gegebenen Wert von Eᵢ hat, wobei die mittlere Dotierstoffdichte des Materials beim Maximum als n_{b}, max bezeichnet wird,
b) eine Einrichtung zum Herstellen von elektrischem Kontakt (14, 15, 16) jeweils zum ersten, zweiten und dritten Bereich, und
c) eine Einrichtung, die das Injizieren heißer Elektronen mit mittlerer Energie Ei aus dem ersten in den zweiten Bereich bewirken kann, wobei wenigstens ein wesentlicher Anteil der injizierten heißen Elektronen die Grenzfläche zwischen dem zweiten und dritten Bereich passieren, dadurch gekennzeichnet,
daß der dritte Bereich einen undotierten oder relativ schwach dotierten Abschnitt der Dicke Z_{c} in Kontakt mit dem zweiten Bereich und einen relativ hoch dotierten Abschnitt, der beabstandet zum zweiten Bereich ist, umfaßt, wobei Z_{c} höchstens 100 nm beträgt.

2. Transistor nach Anspruch 1, bei welchem n_{b} wenigstens 10²⁰ cm⁻³ ist.

3. Transistor nach Anspruch 1, bei welchem die Dotierstoffatome im zweiten Bereich eine Nicht-Zufallsverteilung haben, wobei die elastische Streurate (1/τₑₗ) der heißen Elektronen wesentlich niedriger als in einem ansonsten identischen Transistor ist, in welchem die Dotierstoffatome im zweiten Bereich eine Zufallsverteilung haben.

4. Transistor nach Anspruch 3, bei welchem die Nicht-Zufallsverteilung eine räumliche nicht gleichförmige Verteilung mit einer oder mehreren Schichten von relativ hoch dotiertem Material umfaßt, wobei im Falle von mehr als einer hoch dotierten Schicht eine Schicht von undotiertem oder relativ schwach dotiertem Material zwischen zwei benachbarten hochdotierten Schichten ist.

5. Transistor nach Anspruch 3, bei welchem die Nicht-Zufallsverteilung wesentliches Ordnen der Dotierstoffatome in wenigstens einem Teil des zweiten Bereichs umfaßt.

6. Transistor nach Anspruch 5, bei welchem ein Teil des zweiten Bereichs eine Schicht von relativ hoch dotiertem Material ist, das von einer ähnlichen Schicht durch eine Schicht von undotiertem oder relativ schwach dotiertem Material getrennt ist.

7. Transistor nach Anspruch 1, bei welchem der dritte Bereich aus Verbindungshalbleitermaterial hergestellt ist, welches eine Leitungsbandbreite E_{bw} und eine Bandlückenbreite E_{g} derart hat, daß E_{bw} - E_{g} wesentlich größer als E_{bw} - E_{g} von GaAs ist.

8. Transistor nach Anspruch 1, bei welchem der erste Bereich n-Typ InP umfaßt.

9. Transistor nach Anspruch 1, bei welchem
i) n_{b} wenigstens 2 x 10²⁰ cm⁻³ ist,
ii) die Dotierstoffatome im zweiten Bereich eine räumlich nicht-gleichförmige Verteilung haben, welche wenigstens zwei Schichten von relativ hoch dotiertem Material mit einer Schicht von undotiertem oder relativ schwach dotiertem Material zwischen diesen umfasst,
iii) die Dotierstoffatome in den wenigstens zwei Schichten im wesentlichen geordnet sind,
iv) der zweite und dritte Bereich aus einem Verbindungshalbleitermaterial hergestellt ist, welches eine Leitungsbandbreite E_{bw} und Bandlückenbreite E_{g} derart hat, daß E_{bw} - E_{g} größer als ungefähr 0,6 eV ist und
v) der relativ hoch dotierte Abschnitt des dritten Bereichs wenigstens 10¹⁹ Dotierstoffatom pro cm³ hat.

## Revendications

1. Un transistor à électrons chauds bipolaire (10) comprenant
a) une région d'émission d'électrons (11) appelée ci-après "la première région", une région de collecte d'électrons (13) appelée ci-après "la troisième région", et une seconde région (12) entre les première et troisième régions, formant des interfaces et étant épitaxiale vis-à-vis de ces dernières, chacune des première, seconde et troisième régions consistant en un matériau semiconducteur, la composition du matériau de la seconde région étant différente de celle du matériau de la première région à l'interface entre les première et seconde régions, et étant la même que la composition du matériau de la troisième région, au moins une partie de chacune des première et troisième régions ayant une conductivité de type n, et au moins une partie de la seconde région ayant une conductivité de type p, la seconde région étant associée à une épaisseur Z_{b}, une résistance de base R_{b}, une densité moyenne de dopant n_{b}, une vitesse de dispersion inélastique 1/τᵢₙ pour les électrons chauds, et une vitesse de dispersion élastique 1/τₑₗ pour les électrons chauds, le matériau de la seconde région étant tel que la vitesse de dispersion inélastique 1/τᵢₙ varie en fonction de la densité moyenne de dopant du matériau et présente un maximum pour une valeur donnée de Eᵢ, la densité moyenne de dopant du matériau au maximum étant désignée par n_{b,max}, et n_{b} étant supérieure à n_{b,max} ;
b) des moyens établissant un contact électrique (14, 15, 16) respectivement avec les première, seconde et troisième régions ; et
c) des moyens conçus pour provoquer une injection d'électrons chauds d'énergie moyenne Eᵢ dans la seconde région, à partir de la première région, au moins une partie notable des électrons chauds injectés traversant l'interface entre les seconde et troisième régions ;
CARACTERISE EN CE QUE
d) la troisième région comprend une partie non dopée ou relativement faiblement dopée, d'épaisseur Z_{c}, en contact avec la seconde région, et une partie relativement fortement dopée qui est à distance de la seconde région, avec Z_{c} au plus égale à 100 nm.

2. Le transistor de la revendication 1, dans lequel n_{b} est au moins de 10²⁰ cm⁻³.

3. Le transistor de la revendication 1, dans lequel les atomes de dopant dans la seconde région ont une répartition non aléatoire, grâce à quoi la vitesse de dispersion élastique (1/τₑₗ) des électrons chauds est notablement inférieure à celle que l'on observe dans un transistor par ailleurs identique dans lequel les atomes de dopant dans la seconde région ont une répartition aléatoire.

4. Le transistor de la revendication 3, dans lequel la répartition non aléatoire comprend une répartition non uniforme au point de vue spatial comprenant une ou plusieurs couches de matériau relativement fortement dopé avec, dans le cas où il y a plus d'une couche fortement dopée, une couche de matériau non dopé ou relativement faiblement dopé entre deux couches fortement dopées adjacentes quelconques.

5. Le transistor de la revendication 3, dans lequel la répartition non aléatoire comprend une mise en ordre notable des atomes de dopant dans au moins une partie de la seconde région.

6. Le transistor de la revendication 5, dans lequel la partie précitée de la seconde région est une couche de matériau relativement fortement dopé qui est séparée d'une couche similaire par une couche de matériau non dopé ou relativement faiblement dopé.

7. Le transistor de la revendication 1, dans lequel la troisième région est formée par un matériau semiconducteur composé ayant une largeur de bande de conduction E_{bw} et une largeur de bande interdite E_{g}, telles que la différence E_{bw}-E_{g} soit notablement supérieure à la différence E_{bw}-E_{g} du GaAs.

8. Le transistor de la revendication 1, dans lequel la première région consiste en InP de type n.

9. Le transistor de la revendication 1, dans lequel
i) n_{b} est au moins de 2 x 10²⁰ cm⁻³ ;
ii) les atomes de dopant dans la seconde région ont une répartition non uniforme au point de vue spatial, comprenant au moins deux couches de matériau relativement fortement dopé avec une couche de matériau non dopé ou relativement faiblement dopé entre elles ;
iii) les atomes de dopant dans les dites au moins deux couches sont notablement ordonnés ;
iv) les seconde et troisième régions sont formées par un matériau semiconducteur composé ayant une largeur de bande de conduction E_{bw} et une largeur de bande interdite E_{g}, telles que la différence E_{bw}-E_{g} soit supérieure à environ 0,6 eV ; et
v) la partie relativement fortement dopée de la troisième région contient au moins 10¹⁹ atomes de dopant par cm³.
